# EUROPEAN PATENT APPLICATION

(11) **EP 4 729 792 A1**
(43) Date of publication of application: **22.04.2026**
(21) Application number: 24823008.8
(22) Date of filing: 29.01.2024
(51) Int. Cl.: F15B 15/28, G01B 7/00

(54) **POSITION DETECTION SWITCH**

(30) Priority: 15.06.2023 JP 2023098327
(71) Applicant: SMC Corporation, Tokyo 104-0031 (JP)
(72) Inventor: SAITO, Makoto, 300-2493 Ibaraki (JP); FUJITA, Takashi, 300-2493 Ibaraki (JP); SOMA, Ryosuke, 300-2493 Ibaraki (JP)
(74) Representative: Keil & Schaafhausen Patentanwälte PartGmbB
(86) International application number: PCT/JP2024/002658
(87) International publication number: WO 2024/257384

(57) **Abstract**

An area transition information generation unit (20) determines a piston area on the basis of the outputs of first to third MR sensors (12, 14, 16), updates area transition information when the piston area transitions between two continuous areas, and does not update the area transition information when the piston area jumps and transitions between two non-continuous areas. A switch signal generation unit (28) switches a switch signal on the basis of at least the area transition information.

## Description

### TECHNICAL FIELD

The present invention relates to a position detecting switch (position detection switch) that detects the position of a piston of a fluid pressure cylinder.

### BACKGROUND ART

Conventionally, a position detecting switch is known which detects a position of a piston by mounting a magnet (a permanent magnet) on the piston, and providing a magnetic sensor on a cylinder tube that detects a magnetic field of the magnet.

In the case that such a position detecting switch is used in an environment in which an external magnetic field is present, the position of the piston may be erroneously detected due to an influence of the external magnetic field. Position detecting switches that do not erroneously detect the position of the piston even when an external magnetic field acts on them are also known.

For example, in JP H06-249605 A, there is described a device in which two magnetic sensors are placed at separate positions along a direction of movement of a piston, and which detect that the piston is in a specific position when the two magnetic sensors detect a magnetic field with a time interval that is greater than or equal to a predetermined value. In the case that a strong external magnetic field from a welding machine acts on these magnetic sensors, the two magnetic sensors turn on almost simultaneously, thereby making it possible to distinguish between the magnetic field of the magnet that is mounted on the piston and the external magnetic field.

### SUMMARY OF THE INVENTION

However, in the case that a placement spacing between the two magnetic sensors in JP H06-249605 A is small, and when the velocity of the piston is small, the two magnetic sensors almost simultaneously detect and turn ON the magnetic field of the magnet that is mounted on the piston. In order to avoid this, when the placement spacing between the two magnetic sensors is increased, the two magnetic sensors will not be capable of simultaneously receiving an external magnetic field of the same strength when the external magnetic field has weakened.

The present invention has the object of solving the aforementioned problem.

A position detecting switch according to the present invention includes first through third MR sensors configured to detect a magnetic field of a magnet configured to be mounted on a piston of a fluid pressure cylinder, an area transition information generating unit and a switch signal generating unit. The area transition information generating unit determines a piston area based on the outputs of the first to third MR sensors, and updates the area transition information in the case that the piston area has transitioned between two continuous areas, but does not update the area transition information in the case that a jump transition has occurred between two discontinuous areas. The switch signal generating unit switches the switch signal based on at least the area transition information, and the switch signal is in a predetermined state when the piston is in a predetermined operating range.

According to the above-described position detecting switch, a determination is made as to whether the piston area has transitioned between two continuous areas, or whether a jump transition has occurred between two discontinuous areas. Therefore, an external magnetic field such as a welding magnetic field or the like can be reliably distinguished from a cylinder magnetic field, and thereby the switch signal can be switched.

### BRIEF DESCRIPTION OF DRAWINGS

[FIG. 1] FIG. 1 is a diagram showing together with a fluid pressure cylinder a basic configuration of a position detecting switch according to a first embodiment of the present invention;
[FIG. 2] FIG. 2 is a diagram showing outputs of first to third MR sensors in the position detecting switch of FIG. 1;
[FIG. 3] FIG. 3 is a block diagram of the position detecting switch of FIG. 1; and
[FIG. 4] FIG. 4 is a block diagram of a position detecting switch according to a second embodiment of the present invention.

### DETAILED DESCRIPTION OF THE INVENTION

Hereinafter, a plurality of preferred embodiments concerning a position detecting switch according to the present invention will be described with reference to the accompanying drawings. In the following description, when terms relating to left and right directions are used, for the sake of convenience, such terms refer to the directions shown in the drawings, however, the actual arrangement of the constituent members and the like are not limited thereby.

### (First Embodiment)

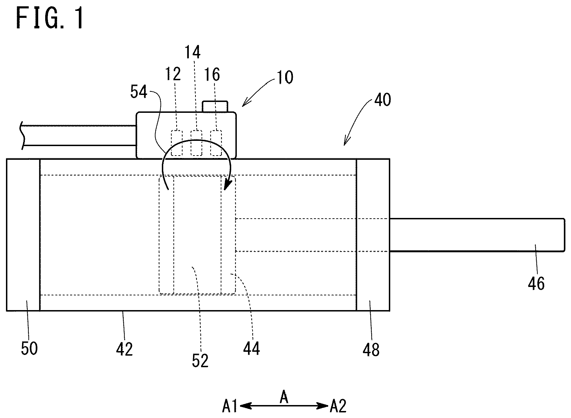

A description will be given with reference to FIG. 1 to FIG. 3 concerning a position detecting switch 10 according to a first embodiment of the present invention. A fluid pressure cylinder 40 in which the position detecting switch 10 is mounted is used, for example, in order to clamp a workpiece to be welded.

As shown in FIG. 1, the fluid pressure cylinder 40 includes a cylinder tube 42, a piston 44 that is slidably disposed inside the cylinder tube 42, and a piston rod 46 that is connected to the piston 44. A right end of the cylinder tube 42 is sealed by a rod cover 48, and a left end of the cylinder tube 42 is sealed by a head cover 50. In the following description, the displacement direction (a left and right direction) of the piston 44 is referred to as an A direction. The displacement direction of the piston 44 toward the head cover 50 is referred to as an A1 direction, and the displacement direction of the piston 44 toward the rod cover 48 is referred to as an A2 direction.

An annular shaped magnet (a permanent magnet) 52 is mounted on an outer circumferential portion of the piston 44. The magnet 52 is magnetized in the A direction, a left end surface of the magnet 52 is an N pole, and a right end surface thereof is an S pole. A magnetic field (a magnetic flux) 54 is formed circumferentially around the magnet 52, which emerges from a left end surface of the magnet 52, passes through an outer side in the diametrical direction of the magnet 52, and returns to a right end surface of the magnet 52. In order to distinguish the magnetic field from an external magnetic field, the magnetic field 54 generated by the magnet 52 is referred to as a "cylinder magnetic field." According to the present embodiment, the left end surface of the magnet 52 is described as being a N pole, and the right end surface is described as being an S pole, however, the N pole and the S pole may be reversed.

The position detecting switch 10 includes first to third MR sensors 12, 14, and 16, and is mounted on an outer side of a cylinder tube 42. The first to third MR sensors 12, 14, and 16 are magnetic sensors in which there are used magnetoresistive effect elements, and have the same output characteristics. The first to third MR sensors 12, 14, and 16 are arranged at equal intervals in the A direction.

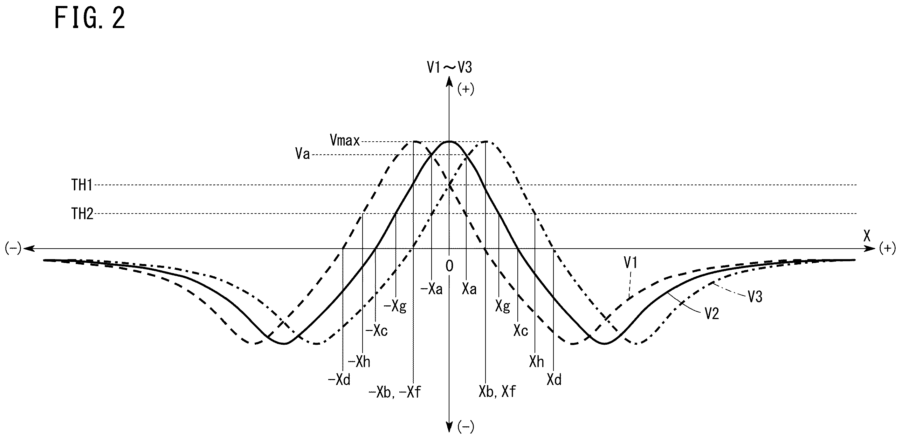

FIG. 2 is a diagram showing outputs V1 to V3 of the first to third MR sensors 12, 14, and 16 in response to a position X of the piston 44. The horizontal axis represents the position X of the piston 44, and the vertical axis represents the outputs V1 to V3 of the first to third MR sensors 12, 14, and 16. An output curve of the first MR sensor 12 is shown by a dotted line. An output curve of the second MR sensor 14 is shown by a solid line. An output curve of the third MR sensor 16 is shown by a one-dot dashed line. Concerning the A direction, when the center of the magnet 52 is at a position corresponding to the second MR sensor 14 (refer to FIG. 1), the piston 44 is at the origin (X = 0). In the case that the piston 44 is displaced from the origin in the A2 direction, the value of X is positive, and in the case that the piston 44 is displaced from the origin in the A1 direction, the value of X is negative.

An output V2 of the second MR sensor 14 has a maximum value Vmax when X = 0. The output V2 of the second MR sensor 14 is zero when X = Xc and X = -Xc, is positive within a range of -Xc < X < Xc, and is negative within a range of X < -Xc and X > Xc.

The output curve of the first MR sensor 12 is obtained by shifting the output curve of the second MR sensor 14 in a leftward direction by Xb. The output V1 of the first MR sensor 12 becomes a maximum value Vmax when X = -Xb. The output curve of the third MR sensor 16 is obtained by shifting the output curve of the second MR sensor 14 in a rightward direction by Xb. The output V3 of the third MR sensor 16 becomes a maximum value Vmax when X = Xb. When Xd = Xb + Xc, the output V1 of the first MR sensor 12 is zero when X = -Xd, and the output V3 of the third MR sensor 16 is zero when X = Xd.

The output curve of the first MR sensor 12 intersects the output curve of the second MR sensor 14 at X = -Xa (-Xb < -Xa). At X = -Xa, the output V1 of the first MR sensor 12 and the output V2 of the second MR sensor 14 are both Va. The output curve of the third MR sensor 16 intersects the output curve of the second MR sensor 14 at X = Xa (Xa < Xb). At X = Xa, the output V2 of the second MR sensor 14 and the output V3 of the third MR sensor 16 are both Va.

In order to determine whether or not the piston 44 is in an optimum position, the output V2 of the second MR sensor 14 is compared with an optimum position threshold value TH1. When the position X of the piston 44 is Xf and -Xf, the output V2 of the second MR sensor 14 is equal to the optimum position threshold value TH1. When V2 ≥ TH1, it is determined that the piston 44 is in the optimum position (-Xf ≤ X ≤ Xf). The fact that the piston 44 is in the optimum position is notified to the operator, for example, by illuminating a green indicator light (a first indicator light). Moreover, according to the present embodiment, Xf = Xb.

In order to determine whether or not the piston 44 is in the predetermined operating range (hereinafter simply referred to as an "operating range") that includes the optimum position, the outputs V1 to V3 of the first to third MR sensors 12, 14, 16 are compared with an operating range threshold value TH2. The operating range threshold value TH2 is less than the optimum position threshold value TH1. When the position X of the piston 44 is Xg (Xf < Xg < Xc) and -Xg, the output V2 of the second MR sensor 14 is equal to the operating range threshold value TH2. When the position X of the piston 44 is Xh (Xc < Xh < Xd), the output V3 of the third MR sensor 16 is equal to the operating range threshold value TH2. When the position X of the piston 44 is -Xh, the output V1 of the first MR sensor 12 is equal to the operating range threshold value TH2.

In the case that the position X of the piston 44 changes from -Xd to Xd, when the output V2 of the second MR sensor 14 becomes greater than or equal to TH2, it is determined that the piston 44 has entered into the operating range. Thereafter, when the output V3 of the third MR sensor 16 falls below TH2, it is determined that the piston 44 has fallen outside of the operating range. More specifically, in the case that the piston 44 is displaced in the A2 direction, the operating range is -Xg ≤ X ≤ Xh. In the case that the position X of the piston 44 changes from Xd to -Xd, when the output V2 of the second MR sensor 14 becomes greater than or equal to TH2, it is determined that the piston 44 has entered into the operating range. Thereafter, when the output V1 of the first MR sensor 12 falls below TH2, it is determined that the piston 44 has fallen outside of the operating range. More specifically, in the case that the piston 44 is displaced in the A1 direction, the operating range is -Xh ≤ X ≤ Xg. According to the present embodiment, the operating range becomes different in the case that the piston 44 is displaced in the A1 direction and in the case of being displaced in the A2 direction, however, the operating range may be the same in the case that the piston 44 is displaced in the A1 direction and in the case of being displaced in the A2 direction.

When it is determined that the piston 44 has entered into the operating range, the switch signal SW switches from OFF to ON. When it is determined that the piston 44 has fallen outside of the operating range, the switch signal SW switches from ON to OFF. In the case that the switch signal SW is ON and the piston 44 is not in the optimum position, for example, a red indicator light (a second indicator light) is turned ON. By the red indicator light being turned ON, the operator is capable of recognizing that the piston 44 has deviated from the optimum position. As for the cause of the piston 44 being deviated from the optimum position, there may be considered that the piston 44 is in an unstable region, or that the mounting position of the position detecting switch 10 with respect to the cylinder tube 42 is displaced or shifted due to vibration. The relationship between the operating range and the switch signal SW may be reversed. More specifically, there may be a relationship in which the switch signal SW is switched from ON to OFF when it is determined that the piston 44 has entered into the operating range, and in which the switch signal SW is switched from OFF to ON when it is determined that the piston 44 has fallen outside of the operating range. In essence, it is sufficient insofar as it is possible to determine, by means of the switch signal SW, whether the piston 44 has entered into the operating range, or whether the piston 44 has fallen outside of the operating range.

Concerning the position X of the piston 44, a range from - Xd to Xd is divided into six continuous areas. The area -Xd ≤ X < -Xc is the first area A1, and the area -Xc ≤ X < -Xa is the second area A2. The area -Xa ≤ X < 0 is the third area A3, and the area 0 ≤ X ≤ Xa is the fourth area A4. The area Xa < X ≤ Xc is the fifth area A5, and the area Xc < X ≤ Xd is the sixth area A6. The position -Xh of the piston 44 that was described above is included within the first area A1. The position -Xg of the piston 44 that was described above is included within the second area A2. The position Xg of the piston 44 that was described above is included within the fifth area A5. The position Xh of the piston 44 that was described above is included within the sixth area A6.

Whether the piston 44 is within any of the first to sixth areas A1 to A6 is determined based on the outputs V1 to V3 of the first to third MR sensors 12, 14, and 16. Specifically, when the inequalities V1 ≥ 0 and V2 < 0 are satisfied, it is determined that the piston 44 is within the first area A1. When the inequalities V3 < V2 < V1 and V2 ≥ 0 are satisfied, it is determined that the piston 44 is within the second area A2. When the inequalities V3 < V1 ≤ V2 and V1 > 0 are satisfied, it is determined that the piston 44 is within the third area A3. When the inequalities V1 ≤ V3 ≤ V2 and V3 > 0 are satisfied, it is determined that the piston 44 is within the fourth area A4. When the inequalities V1 < V2 < V3 and V2 ≥ 0 are satisfied, it is determined that the piston 44 is within the fifth area A5. When the inequalities V2 < 0 and V3 ≥ 0 are satisfied, it is determined that the piston 44 is within the sixth area A6.

Whether the piston 44 is within a seventh area A7, which is an area outside of the first to sixth areas A1 to A6, is also determined based on the outputs V1 to V3 of the first to third MR sensors 12, 14, and 16. Stated otherwise, whether the piston 44 is within an area in which X < -Xd or within an area in which X > Xd is also determined based on the outputs V1 to V3 of the first to third MR sensors 12, 14, and 16. Specifically, when the outputs V1, V2, and V3 are all negative, it is determined that the piston 44 is within the seventh area A7. Instead of this determination method, it may be determined that the piston 44 is within the seventh area A7 when the absolute values of the outputs V1, V2, and V3 are all smaller than a predetermined threshold value. The predetermined threshold value in this case is smaller than the operating range threshold value TH2.

The method of determining which of the first to seventh areas A1 to A7 the piston 44 is in based on the outputs V1 to V3 of the first to third MR sensors 12, 14, and 16 is not necessarily limited to the above-described specific example. For example, as the condition for determining whether the piston 44 is in the first area A1, apart from the inequalities V1 ≥ 0 and V2 < 0, the inequality V3 < V2 < V1 may also be added. Further, according to the present embodiment, the area in which the piston 44 is positioned (hereinafter referred to as the "piston area") is divided into seven areas, however, the number of the piston areas is not necessarily limited to this feature.

The determination of which of the first to seventh areas A1 to A7 the piston area is in is carried out at each instance of a predetermined control period. In a certain control period, it is determined that the piston 44 is within one from among the first to seventh areas A1 to A7, and in a next control period, it is determined that the piston 44 is in another area. More specifically, it is assumed that a newly determined piston area (hereinafter referred to as a "current piston area") differs from a previously determined piston area (hereinafter referred to as a "previous piston area"), and that the piston area has transitioned.

When the piston area transitions due to a change in the cylinder magnetic field, the current piston area is an area that is continuous with the previous piston area. On the other hand, in the case that the piston area has transitioned due to a change in the welding magnetic field, the current piston area is an area that is discontinuous with the previous piston area. When the welding magnetic field acts on the first to third MR sensors 12, 14, and 16, the outputs V1 to V3 of the first to third MR sensors 12, 14, and 16 change suddenly, and therefore, in a normal control period, the transition appears to jump between two discontinuous areas. By determining whether or not the piston area has transitioned between two continuous areas, or whether a jump transition has occurred between two discontinuous areas, the external magnetic field such as the welding magnetic field or the like can be distinguished from the cylinder magnetic field.

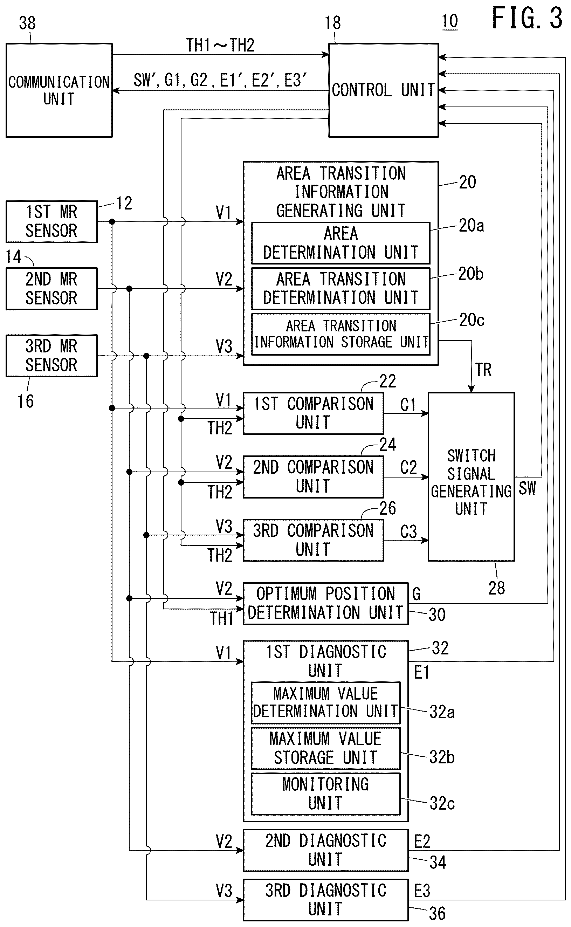

Concerning the operation of the position detecting switch 10, a description thereof will be given in further detail with reference to the block diagram of FIG. 3. The position detecting switch 10 includes, in addition to the first to third MR sensors 12, 14, and 16, a control unit 18, an area transition information generating unit 20, first to third comparison units 22, 24, and 26, a switch signal generating unit 28, an optimum position determination unit 30, first to third diagnostic units 32, 34, and 36, and a communication unit 38. The optimum position threshold value TH1 and the operating range threshold value TH2 are retained in the control unit 18.

The area transition information generating unit 20 includes an area determination unit 20a, an area transition determination unit 20b, and an area transition information storage unit 20c. The outputs V1 to V3 of the first to third MR sensors 12, 14, and 16 are input to the area determination unit 20a at each instance of the control period. The area determination unit 20a, based on the outputs V1 to V3 of the first to third MR sensors 12, 14, and 16, determines which of the first to seventh areas A1 to A7 the piston area is, and delivers the current piston area to the area transition determination unit 20b. Moreover, in the case that it is not determined that the piston area is any one of the first to seventh areas A1 to A7, such a situation is treated as an error.

The area transition determination unit 20b stores the previous piston area, and compares the current piston area with the previous piston area. In the case that the current piston area differs from the previous piston area, and further, is an area that is continuous with the previous piston area, the area transition determination unit 20b updates the area transition information TR that is stored in the area transition information storage unit 20c. In the case that the current piston area is discontinuous with the previous piston area, the area transition information TR is not updated. The area transition determination unit 20b outputs the area transition information TR, which is stored in the area transition information storage unit 20c, to the switch signal generating unit 28 at each instance of the control period.

For example, in an nth control period, it is assumed that the piston area transitions from the first area A1 to the second area A2, and in the (n+1)th control period, the piston area remains within the second area A2. In this case, each of the area transition information TR that is output in the nth control cycle, and further, the area transition information TR that is output in the (n+1)th control cycle is information indicating that the piston area has transitioned from the first area A1 to the second area A2. More specifically, the area transition determination unit 20b outputs the latest area transition information TR to the switch signal generating unit 28 at each instance of the control period.

In this instance, information indicating that the piston area has transitioned from the first area A1 to the second area A2 is denoted by TR12, and information indicating that the piston area has transitioned from the second area A2 to the first area A1 is denoted by TR21. The same applies to the information indicating the transitions between other combinations of two areas. There are a total of 14 types of the area transition information TR, namely, TR71, TR12, TR23, TR34, TR45, TR56, TR67, TR76, TR65, TR54, TR43, TR32, TR21, and TR17.

The output V1 of the first MR sensor 12 is input to the first comparison unit 22 at each instance of the control period. The first comparison unit 22 retains the operating range threshold value TH2 that is input thereto in advance from the control unit 18. The first comparison unit 22 compares the output V1 of the first MR sensor 12 with the operating range threshold value TH2, and outputs a first comparison signal C1 to the switch signal generating unit 28. When the output V1 of the first MR sensor 12 is less than the operating range threshold value TH2, the first comparison signal C1 is 1. When the output V1 of the first MR sensor 12 is greater than or equal to the operating range threshold value TH2, the first comparison signal C1 is 0.

The output V2 of the second MR sensor 14 is input to the second comparison unit 24 at each instance of the control period. The second comparison unit 24 retains the operating range threshold value TH2 that is input thereto in advance from the control unit 18. The second comparison unit 24 compares the output V2 of the second MR sensor 14 with the operating range threshold value TH2, and outputs a second comparison signal C2 to the switch signal generating unit 28. When the output V2 of the second MR sensor 14 is greater than or equal to the operating range threshold value TH2, the second comparison signal C2 is 1, and when the output V2 of the second MR sensor 14 is less than the operating range threshold value TH2, the second comparison signal C2 is 0.

The output V3 of the third MR sensor 16 is input to a third comparison unit 26 at each instance of the control period. The third comparison unit 26 retains the operating range threshold value TH2 that is input thereto in advance from the control unit 18. The third comparison unit 26 compares the output V3 of the third MR sensor 16 with the operating range threshold value TH2, and outputs a third comparison signal C3 to the switch signal generating unit 28. When the output V3 of the third MR sensor 16 is less than the operating range threshold value TH2, the third comparison signal C3 is 1. When the output V3 of the third MR sensor 16 is greater than or equal to the operating range threshold value TH2, the third comparison signal C3 is 0.

The switch signal generating unit 28 generates the switch signal SW based on the area transition information TR and the first to third comparison signals C1 to C3. The switch signal generating unit 28, at each instance of the control period, outputs the switch signal SW to the control unit 18.

A case will be considered in which the piston 44 is displaced in the A2 direction from the area in which X < -Xd to the area in which X > Xd. In the case that the area transition information TR is TR71, the switch signal SW is switched OFF. In the case that the area transition information TR is TR12, and further, the second comparison signal C2 is 0, the switch signal SW is switched OFF. In the case that the area transition information TR is TR12, and further, the second comparison signal C2 is 1, the switch signal SW is switched ON. In the case that the area transition information TR is TR23, TR34, or TR45, the switch signal SW is switched ON. In the case that the area transition information TR is TR56, and further, the third comparison signal C3 is 0, the switch signal SW is switched ON. In the case that the area transition information TR is TR56, and further, the third comparison signal C3 is 1, the switch signal SW is switched OFF. In the case that the area transition information TR is TR67, the switch signal SW is switched OFF.

A case will be considered in which the piston 44 is displaced in the A1 direction from the area in which X > Xd to the area in which X < -Xd. In the case that the area transition information TR is TR76, the switch signal SW is switched OFF. In the case that the area transition information TR is TR65, and further, the second comparison signal C2 is 0, the switch signal SW is switched OFF. In the case that the area transition information TR is TR65, and further, the second comparison signal C2 is 1, the switch signal SW is switched ON. In the case that the area transition information TR is TR54, TR43, or TR32, the switch signal SW is switched ON. In the case that the area transition information TR is TR21, and further, the first comparison signal C1 is 0, the switch signal SW is switched ON. In the case that the area transition information TR is TR21, and further, the first comparison signal C1 is 1, the switch signal SW is switched OFF. In the case that the area transition information TR is TR17, the switch signal SW is switched OFF.

As can be understood from the above description, in the case that the piston 44 is displaced in the A1 direction and in the case of being displaced in the A2 direction, the second comparison signal C2 is used in order to switch the switch signal SW from OFF to ON. The first comparison signal C1, in the case that the piston 44 is displaced in the A1 direction, is used in order to switch the switch signal SW from ON to OFF. The third comparison signal C3, in the case that the piston 44 is displaced in the A2 direction, is used in order to switch the switch signal SW from ON to OFF. The operation regarding the ON/OFF switching of the switch signal SW may be reversed from that described above.

The output V2 of the second MR sensor 14 is input to the optimum position determination unit 30 at each instance of the control period. The optimum position determination unit 30 retains the optimum position threshold value TH1 that is input thereto in advance from the control unit 18. The optimum position determination unit 30 compares the output V2 of the second MR sensor 14 with the optimum position threshold value TH1, and generates an optimum position signal G. The optimum position determination unit 30, at each instance of the control period, outputs the optimum position signal G to the control unit 18. When the output V2 of the second MR sensor 14 is greater than or equal to the optimum position threshold value TH1, the optimum position signal G is 1, and when the output V2 of the second MR sensor 14 is less than the optimum position threshold value TH1, the optimum position signal G is 0.

The control unit 18 is capable of communicating bidirectionally with the exterior via the communication unit 38. The control unit 18, in response to the switch signal SW being received from the switch signal generating unit 28, outputs to the exterior via the communication unit 38 a signal SW' that is used to control external devices that operate in association with the fluid pressure cylinder 40. The control unit 18, based on the switch signal SW and the optimum position signal G, outputs a signal for controlling a non-illustrated indicator light. In the case that the switch signal SW is in a predetermined ON or OFF state, and further, when the optimum position signal G is 1, the control unit 18 outputs a command signal G1 to illuminate the indicator lamp in green. In the case that the switch signal SW is in a predetermined ON or OFF state, and further, when the optimum position signal G is 0, the control unit 18 outputs a command signal G2 to illuminate the indicator lamp in red.

The change in the settings of the optimum position threshold value TH1 and the operating range threshold value TH2 with respect to the position detecting switch 10 can be carried out externally. When the control unit 18 receives data in relation to the change in the settings of the optimum position threshold value TH1 via the communication unit 38, the control unit 18 outputs the new optimum position threshold value TH1 to the optimum position determination unit 30. When the control unit 18 receives data in relation to the change in the settings of the operating range threshold value TH2 via the communication unit 38, the control unit 18 outputs the new operating range threshold value TH2 to the first to third comparison units 22, 24, and 26.

The magnetic force of the magnet 52 decreases (demagnetizes) accompanying changes over time. In particular, the magnet 52 is demagnetized when exposed to a welding magnetic field, or alternatively, when placed under a high temperature environment over a prolonged period of time. When such an event occurs, there is a possibility that the maximum value Vmax of the outputs V1 to V3 of the first to third MR sensors 12, 14, and 16 may decrease to such an extent so as not to exceed the optimum position threshold value TH1.

Thus, the first to third diagnostic units 32, 34, and 36 are provided with the aim of monitoring whether or not the maximum value Vmax of the outputs V1 to V3 of the first to third MR sensors 12, 14, and 16 has decreased to greater than or equal to a predetermined value due to changes over time or the like. The output V1 of the first MR sensor 12 is input to the first diagnostic unit 32, the output V2 of the second MR sensor 14 is input to the second diagnostic unit 34, and the output V3 of the third MR sensor 16 is input to the third diagnostic unit 36. Hereinafter, the processing content in the first diagnostic unit 32 will be described, however, such content is the same as the processing content in the second diagnostic unit 34 and the third diagnostic unit 36.

The first diagnostic unit 32 includes a maximum value determination unit 32a, a maximum value storage unit 32b, and a monitoring unit 32c. Each time that the output V1 of the first MR sensor 12 transitions from an increasing state to a decreasing state, the maximum value determination unit 32a transmits the output at that time (the output V1 immediately prior to decreasing) as the maximum value Vmax to the maximum value storage unit 32b. The maximum value storage unit 32b stores in a time series manner the maximum value Vmax data received from the maximum value determination unit 32a.

From among a large number of the maximum value Vmax data that are stored in the maximum value storage unit 32b, the monitoring unit 32c periodically calculates the average value of a most recent predetermined number of data, and compares the calculated value with the average value of an initial predetermined number of data. In the case it is determined that the average value of the most recent predetermined number of data is smaller by at least a predetermined value than the average value of the initial predetermined number of data, a warning signal E1 is output to the control unit 18.

When receiving a warning signal E1 from the monitoring unit 32c of the first diagnostic unit 32, in order to notify that there is a high probability that an event such as lowering of the magnetization of the magnet 52 has occurred, the control unit 18 outputs a warning signal E1' to the exterior via the communication unit 38. In accordance with this feature, it is possible to prompt the operator to perform maintenance such as replacement of component parts, and to prompt the operator to adjust the optimum position threshold value TH1.

According to the present embodiment, the first diagnostic unit 32 monitors the maximum value Vmax of the output V1 of the first MR sensor 12, the second diagnostic unit 34 monitors the maximum value Vmax of the output V2 of the second MR sensor 14, and the third diagnostic unit 36 monitors the maximum value Vmax of the output V3 of the third MR sensor 16. However, the maximum values Vmax of the outputs V1 to V3 of the first to third MR sensors 12, 14, and 16 may be monitored comprehensively by a common diagnostic unit. In the case that the maximum values Vmax of the plurality of outputs V1 to V3 of the first to third MR sensors 12, 14, and 16 have decreased by greater than or equal to a predetermined amount, the likelihood is high that demagnetization of the magnet 52 is the cause. In the case that only a maximum value Vmax of one from among the outputs V1 to V3 of the first to third MR sensors 12, 14, and 16 has decreased by greater than or equal to the predetermined amount, the likelihood is high that a decrease in the sensitivity of the concerned MR sensor is the cause. It is efficient if a common diagnostic unit distinguishes between such circumstances and outputs the warning signal.

According to the present embodiment, the switch signal SW is switched based on at least the area transition information TR, and the area transition information TR is information that is based on the fact that the piston area has transitioned between two continuous areas. Therefore, an external magnetic field such as a welding magnetic field or the like can be reliably distinguished from the cylinder magnetic field, and thereby the switch signal SW can be switched.

### (Second Embodiment)

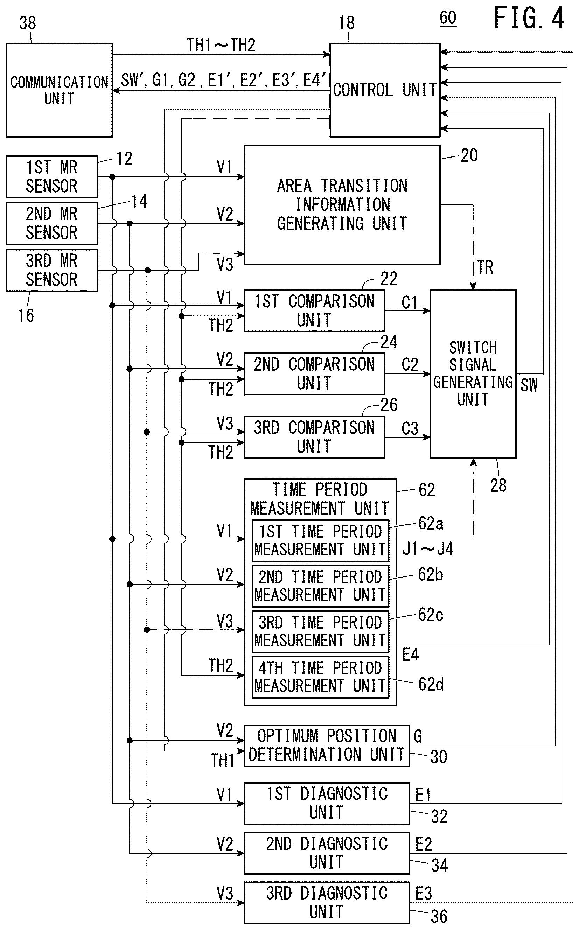

A description will be given with reference to FIG. 4 concerning a position detecting switch 60 according to a second embodiment of the present invention. The position detecting switch 60 differs from the position detecting switch 10 according to the first embodiment, in that it is equipped with a time period measurement unit 62, and adds a condition related to time as a condition for the purpose of switching the switch signal SW. Moreover, it should be noted that the same or equivalent constituent elements as those in the position detecting switch 10 according to the first embodiment are denoted by the same reference numerals, and detailed description of such features will be omitted.

The outputs V1 to V3 of the first to third MR sensors 12, 14, and 16 are input to the time period measurement unit 62 at each instance of the control period. The time period measurement unit 62 retains the operating range threshold value TH2 that is input thereto in advance from the control unit 18. The time period measurement unit 62 is equipped with first to fourth time period measurement units 62a to 62d.

The first time period measurement unit 62a measures a time period from when the output V1 of the first MR sensor 12 has become greater than or equal to the threshold value TH2 until when the output V2 of the second MR sensor 14 becomes greater than or equal to the threshold value TH2. More specifically, the first time period measurement unit 62a measures the time period required for the piston 44 to be displaced in the A2 direction from -Xh to -Xg (hereinafter referred to as a "first displacement time period"). The first time period measurement unit 62a determines whether or not the first displacement time period falls within a predetermined range, and the time period measurement unit 62 outputs a determination signal J1 to the switch signal generating unit 28 at each instance of the control period. When it is determined that the first displacement time period falls within the predetermined range, the determination signal J1 is 1; otherwise, , the determination signal J1 is 0.

The second time period measurement unit 62b measures a time period from when the output V2 of the second MR sensor 14 has become less than the threshold value TH2 until when the output V3 of the third MR sensor 16 becomes less than the threshold value TH2. More specifically, the second time period measurement unit 62b measures the time period required for the piston 44 to be displaced in the A2 direction from Xg to Xh (hereinafter referred to as a "second displacement time period"). The second time period measurement unit 62b determines whether or not the second displacement time period falls within a predetermined range, and the time period measurement unit 62 outputs a determination signal J2 to the switch signal generating unit 28 at each instance of the control period. When it is determined that the second displacement time period falls within the predetermined range, the determination signal J2 is 1; otherwise, the determination signal J2 is 0.

The third time period measurement unit 62c measures a time period from when the output V3 of the third MR sensor 16 has become greater than or equal to the threshold value TH2 until when the output V2 of the second MR sensor 14 becomes greater than or equal to the threshold value TH2. More specifically, the third time period measurement unit 62c measures the time period required for the piston 44 to be displaced in the A1 direction from Xh to Xg (hereinafter referred to as a "third displacement time period"). The third time period measurement unit 62c determines whether or not the third displacement time period falls within a predetermined range, and the time period measurement unit 62 outputs a determination signal J3 to the switch signal generating unit 28 at each instance of the control period. When it is determined that the third displacement time period falls within the predetermined range, the determination signal J3 is 1; otherwise, the determination signal J3 is 0.

The fourth time period measurement unit 62d measures a time period from when the output V2 of the second MR sensor 14 has become less than the threshold value TH2 until when the output V1 of the first MR sensor 12 becomes less than the threshold value TH2. More specifically, the fourth time period measurement unit 62d measures the time period required for the piston 44 to be displaced in the A1 direction from -Xg to -Xh (hereinafter referred to as a "fourth displacement time period"). The fourth time period measurement unit 62d determines whether or not the fourth displacement time period falls within a predetermined range, and the time period measurement unit 62 outputs a determination signal J4 to the switch signal generating unit 28 at each instance of the control period. When it is determined that the fourth displacement time period falls within the predetermined range, the determination signal J4 is 1; otherwise, the determination signal J4 is 0.

The above-described predetermined ranges in relation to the first to fourth displacement time periods are defined using at least a lower limit value that can be assumed from a normal piston velocity. In the case that the measured first to fourth displacement time periods are less than the lower limit value, switching of the switch signal SW is not carried out. In accordance with this feature, it is possible to more reliably prevent the switching of the switch signal SW due to an external magnetic field such as a welding magnetic field or the like. Hereinafter, a description will be given concerning this effect. Moreover, in the case that a later-described warning signal E4 is taken into consideration, the predetermined ranges in relation to the first to fourth displacement time periods may be defined by an upper limit value and a lower limit value that can be assumed from the normal piston velocity.

The switch signal generating unit 28 generates the switch signal SW based on the area transition information TR, the first to third comparison signals C1 to C3, and the determination signals J1 to J4. The switch signal generating unit 28, at each instance of the control period, outputs the switch signal SW to the control unit 18.

A case will be considered in which the piston 44 is displaced in the A2 direction from the area in which X < -Xd to the area in which X > Xd. In the case that the area transition information TR is TR71, the switch signal SW is switched OFF. In the case that the area transition information TR is TR12, and further, the second comparison signal C2 is 0, the switch signal SW is switched OFF. In the case that the area transition information TR is TR12, the second comparison signal C2 is 1, and further, the determination signal J1 is 0, the switch signal SW is switched OFF. In the case that the area transition information TR is TR12, the second comparison signal C2 is 1, and further, the determination signal J1 is 1, the switch signal SW is switched ON.

In the case that the area transition information TR is TR23, TR34, or TR45, the switch signal SW is switched ON. In the case that the area transition information TR is TR56, and further, the third comparison signal C3 is 0, the switch signal SW is switched ON. In the case that the area transition information TR is TR56, the third comparison signal C3 is 1, and further, the determination signal J2 is 0, the switch signal SW is switched ON. In the case that the area transition information TR is TR56, the third comparison signal C3 is 1, and further, the determination signal J2 is 1, the switch signal SW is switched OFF. In the case that the area transition information TR is TR67, the switch signal SW is switched OFF.

A case will be considered in which the piston 44 is displaced in the A1 direction from the area in which X > Xd to the area in which X < -Xd. In the case that the area transition information TR is TR76, the switch signal SW is switched OFF. In the case that the area transition information TR is TR65, and further, the second comparison signal C2 is 0, the switch signal SW is switched OFF. In the case that the area transition information TR is TR65, the second comparison signal C2 is 1, and further, the determination signal J3 is 0, the switch signal SW is switched OFF. In the case that the area transition information TR is TR65, the second comparison signal C2 is 1, and further, the determination signal J3 is 1, the switch signal SW is switched ON.

In the case that the area transition information TR is TR54, TR43, or TR32, the switch signal SW is switched ON. In the case that the area transition information TR is TR21, and further, the first comparison signal C1 is 0, the switch signal SW is switched ON. In the case that the area transition information TR is TR21, the first comparison signal C1 is 1, and further, the determination signal J4 is 0, the switch signal SW is switched ON. In the case that the area transition information TR is TR21, the first comparison signal C1 is 1, and further, the determination signal J4 is 1, the switch signal SW is switched OFF. In the case that the area transition information TR is TR17, the switch signal SW is switched OFF.

As can be understood from the above description, the determination signal J1, in the case that the piston 44 is displaced in the A2 direction, is used in order to switch the switch signal SW from OFF to ON. The determination signal J2, in the case that the piston 44 is displaced in the A2 direction, is used in order to switch the switch signal SW from ON to OFF. The determination signal J3, in the case that the piston 44 is displaced in the A1 direction, is used in order to switch the switch signal SW from OFF to ON. The determination signal J4, in the case that the piston 44 is displaced in the A1 direction, is used in order to switch the switch signal SW from ON to OFF. The operation regarding the ON/OFF switching of the switch signal SW may be reversed from that described above.

In the case that the measured first to fourth displacement time periods are not within the predetermined range, there is a possibility that the cause may be that the air pressure that is supplied to the fluid pressure cylinder 40 is outside of an appropriate range, or the cause may be that constituent parts of the fluid pressure cylinder 40 have deteriorated. In the case that the time period measurement unit 62 has determined that the measured first to fourth displacement time periods are not within the predetermined range, the warning signal E4 is output to the control unit 18. When the control unit 18 receives the warning signal E4 from the time period measurement unit 62, the control unit 18 outputs a warning signal E4' to the exterior via the communication unit 38, in order to notify that there is a high probability that an event such as an improper supply of air pressure or a deterioration of the fluid pressure cylinder 40 has occurred.

According to the present embodiment, the switch signal SW is switched based on at least the area transition information TR and the determination signals J1 to J4. The area transition information TR is information that is based on the transition of the piston between two continuous areas, and the determination signals J1 to J4 are information in which a time period required for the piston 44 to undertake a predetermined displacement is taken into consideration. Therefore, the external magnetic field such as the welding magnetic field or the like can be more reliably distinguished from the cylinder magnetic field, and thereby the switch signal SW can be switched.

The position detecting switch of the present invention is not necessarily limited to the embodiments described above, and it goes without saying that various configurations could be adopted therein without departing from the essence and gist of the present invention.

## Claims

1. A position detecting switch (10, 60) comprising: first through third magnetoresistive sensors (12, 14, 16) configured to detect a magnetic field of a magnet (52) configured to be mounted on a piston (44) of a fluid pressure cylinder (40); an area transition information generating unit (20); and a switch signal generating unit (28),
wherein the area transition information generating unit determines a piston area based on outputs of the first to third magnetoresistive sensors, updates area transition information in a case that the piston area has transitioned between two continuous areas, but does not update the area transition information in a case that a jump transition has occurred between two discontinuous areas, the switch signal generating unit switches the switch signal based on at least the area transition information, and the switch signal is in a predetermined state when the piston is in a predetermined operating range.

2. The position detecting switch according to claim 1, further comprising:
a first comparison unit (22) configured to compare an output of the first magnetoresistive sensor with an operating range threshold value and to output a first comparison signal; a second comparison unit (24) configured to compare an output of the second magnetoresistive sensor with the operating range threshold value and to output a second comparison signal; and a third comparison unit (26) configured to compare an output of the third magnetoresistive sensor with the operating range threshold value and to output a third comparison signal,
wherein the switch signal generating unit switches the switch signal based on the area transition information and the first to third comparison signals.

3. The position detecting switch according to claim 1, wherein the first to third magnetoresistive sensors have same output characteristics, and are disposed at equal intervals along a displacement direction of the piston.

4. The position detecting switch according to claim 1, wherein the piston area is determined based on a magnitude relationship between the outputs of the first to third magnetoresistive sensors.

5. The position detecting switch according to claim 1, further comprising an optimum position determination unit (30) configured to compare the output of the second magnetoresistive sensor with an optimum position threshold value, and to determine whether the piston is in an optimum position, wherein the optimum position is included in the operating range.

6. The position detecting switch according to claim 5, wherein a signal to turn ON a first indicator light is output when the piston is in the optimum position, and a signal to turn ON a second indicator light is output when the piston lies within the operating range but not in the optimum position.

7. The position detecting switch according to claim 1, further comprising:
a first comparison unit (22) configured to compare an output of the first magnetoresistive sensor with an operating range threshold value and to output a first comparison signal; a second comparison unit (24) configured to compare an output of the second magnetoresistive sensor with the operating range threshold value and to output a second comparison signal; a third comparison unit (26) configured to compare an output of the third magnetoresistive sensor with the operating range threshold value and to output a third comparison signal; and a time period measurement unit (62),
wherein, concerning the outputs of two adjacent magnetoresistive sensors from among the first to third magnetoresistive sensors, the time period measurement unit measures a time period from when the output of one magnetoresistive sensor has become greater than or equal to the operating range threshold value until when the output of another magnetoresistive sensor becomes greater than or equal to the operating range threshold value, or alternatively, concerning the outputs of two adjacent magnetoresistive sensors from among the first to third magnetoresistive sensors, the time period measurement unit measures a time period from when the output of one magnetoresistive sensor has become less than the operating range threshold value until when the output of another magnetoresistive sensor becomes less than the operating range threshold value, and determines whether or not the measured time period lies within a predetermined range and outputs a determination signal, and
the switch signal generating unit switches the switch signal based on the area transition information, the first to third comparison signals, and the determination signal.

8. The position detecting switch according to claim 7, wherein in a case that the measured time period does not lie within the predetermined range, the position detecting switch outputs a warning signal.

9. The position detecting switch according to claim 1, further comprising a diagnostic unit (32, 34, 36) configured to monitor whether or not each of maximum values of the outputs of the first to third magnetoresistive sensors has decreased by greater than or equal to a predetermined amount.
